# EUROPEAN PATENT SPECIFICATION

(11) **EP 4 439 784 B1**
(45) Date of publication and mention of the grant of the patent: **19.11.2025**
(21) Application number: 24167845.7
(22) Date of filing: 29.03.2024
(51) Int. Cl.: H01M 10/42, G01R 31/367, G01R 31/392, G01R 31/36

(54) **BATTERY SWELLING AND LIFE PREDICTION METHOD, ELECTROCHEMICAL APPARATUS, AND ELECTRIC DEVICE**
VERFAHREN ZUR VORHERSAGE DER BATTERIESCHWELLUNG UND -LEBENSDAUER, ELEKTROCHEMISCHE VORRICHTUNG UND ELEKTRISCHE VORRICHTUNG
PROCÉDÉ DE PRÉDICTION DE GONFLEMENT ET DE DURÉE DE VIE DE BATTERIE, APPAREIL ÉLECTROCHIMIQUE ET DISPOSITIF ÉLECTRIQUE

(30) Priority: 31.03.2023 CN 202310339603
(43) Date of publication of application: 02.10.2024
(73) Proprietor: Xiamen Ampack Technology Limited, Xiamen City, Fujian Province, 361000 (CN)
(72) Inventor: HOU, Zhihua, Xiamen City, Fujian Province 361000 (CN); WANG, Guifu, Xiamen City, Fujian Province 361000 (CN); XIA, Chao, Xiamen City, Fujian Province 361000 (CN); BIAN, Yuchang, Xiamen City, Fujian Province 361000 (CN)
(74) Representative: Icosa

(56) References cited:
- WO-A1-2022/047204
- CN-A- 115 034 146
- US-B2- 11 079 212

## Description

### TECHNICAL FIELD

This application relates to the field of battery technologies, and specifically, to a method for predicting swelling and life of a battery, an electrochemical apparatus, and an electric device.

### BACKGROUND

Secondary batteries have been widely used in various fields. During use of a secondary battery, swelling occurs in the secondary battery, for example, swelling caused by a thickness change of an electrode plate of the battery, or swelling caused by gas produced due to decomposition of an electrolyte. Swelling of the secondary battery degrades the use performance of the battery, leads to a temperature rise of the battery, or even poses the risk of occurrence of smoke or fire during use of the battery. Therefore, it is necessary to estimate swelling of the secondary battery so as to predict the life of the battery based on the swelling situation of the battery. The secondary battery may be a sodium-ion battery, a lithium-ion battery, a magnesium-ion battery, or the like. Prior art document CN115 034 146 A, US11 079 212 and WO2022/047204 A1 disclose methods for estimating and/or predicting of swelling associated with the rechargeable battery.

### SUMMARY

Some embodiments of this application are intended to provide a method for predicting swelling and life of a battery, an electrochemical apparatus, and an electric device, so as to predict swelling and life of a battery. Specific technical solutions are as follows.

A first aspect of this application provides a method for predicting swelling and life of a battery. The method includes: receiving a battery operating condition parameter and a battery swelling rate threshold; acquiring multiple battery swelling rate versus battery life distribution curves according to the battery operating condition parameter; acquiring a life distribution of the battery corresponding to the battery swelling rate threshold based on the multiple battery swelling rate versus battery life distribution curves; or acquiring a swelling rate distribution of the battery at a specified time or at a specified quantity of cycles based on the multiple battery swelling rate versus battery life distribution curves. The battery operating condition parameter includes at least one of temperature, charge cut-off voltage, discharge cut-off voltage, charge rate, discharge rate, quantity of battery continuous cycles per day, storage voltage, or storage time. The battery swelling rate threshold is a maximum swelling rate allowable by the battery; the life of the battery is represented by time or a quantity of cycles; and the quantity of battery continuous cycles per day is a quantity of cycles in which the battery is discharged from the charge cut-off voltage to the discharge cut-off voltage and then charged to the charge cut-off voltage.

Some embodiments of this application have the following beneficial effects: Some embodiments of this application provide a method for predicting swelling and life of a battery, an electrochemical apparatus, and an electric device. With a battery operating condition parameter received, multiple battery swelling rate versus battery life distribution curves can be obtained, such that a life distribution of the battery corresponding to a preset battery swelling rate threshold can be obtained. Alternatively, a swelling rate distribution of the battery corresponding to a specified battery use time can be obtained based on the multiple battery swelling rate versus battery life distribution curves. In this way, the swelling and life of the battery are predicted.

In an embodiment of this application, the acquiring a life distribution of the battery corresponding to the battery swelling rate threshold based on the multiple battery swelling rate versus battery life distribution curves further includes: acquiring a life of the battery corresponding to the battery swelling rate threshold, where the life of the battery is represented by a time extremum corresponding to the battery swelling rate threshold or represented by a time average corresponding to the battery swelling rate threshold; or, the acquiring a swelling rate distribution of the battery at a specified time or at a specified quantity of cycles based on the multiple battery swelling rate versus battery life distribution curves further includes: acquiring a swelling rate of the battery, where the swelling rate of the battery is represented by a swelling rate extremum of the battery at a specified time or at a specified quantity of cycles or represented by a swelling rate average of the battery at a specified time or at a specified quantity of cycles. In this embodiment of this application, based on the multiple battery swelling rate versus battery life distribution curves, the life of the battery corresponding to the preset battery swelling rate threshold can be acquired, or the swelling rate of the battery in a specified time or at a specified quantity of cycles can be acquired.

In an embodiment of this application, the acquiring multiple battery swelling rate versus battery life distribution curves according to the battery operating condition parameter further includes: inputting the battery operating condition parameter into a battery swelling rate model to obtain multiple battery swelling rate versus battery life distribution curves.

In an embodiment of this application, the temperature is represented by geographical location data; and the inputting the battery operating condition parameter into a battery swelling rate model to obtain multiple battery swelling rate versus battery life distribution curves includes: inputting the geographical location data, the charge cut-off voltage, the discharge cut-off voltage, the charge rate, the discharge rate, and the quantity of battery continuous cycles per day into the battery swelling rate model to obtain multiple battery swelling rate versus battery life distribution curves.

In an embodiment of this application, the battery swelling rate model is obtained in the following manner: acquiring a cell connection mode in the battery; establishing a battery cycling swelling rate model of the battery based on the cell connection mode and a cell cycling swelling rate model; establishing a battery storage swelling rate model of the battery based on the cell connection mode and the cell storage swelling rate model; and establishing the battery swelling rate model of the battery based on the battery cycling swelling rate model and the battery storage swelling rate model; where the cell cycling swelling rate model represents a relationship between a quantity of cell cycles and a cell swelling rate, and the cell storage swelling rate model represents a relationship between a cell storage time and the cell swelling rate. In this embodiment of this application, in the process of establishing the battery swelling rate model, the cell connection mode in the battery is considered, which can implement establishment of battery swelling rate models of batteries adopting different cell connection modes.

In an embodiment of this application, the cell cycling swelling rate model is obtained in the following manner: acquiring cell cycling swelling rate data of the battery corresponding to a cycling operating condition parameter set, and establishing the cell cycling swelling rate model according to the cycling operating condition parameter set and the cell cycling swelling rate data, where the cell cycling swelling rate model represents a correspondence between the quantity of cell cycles and the cell swelling rate; and/or, the cell storage swelling rate model is obtained in the following manner: acquiring cell storage swelling rate data of the battery corresponding to a storage operating condition parameter set, and establishing the cell storage swelling rate model according to the storage operating condition parameter set and the cell storage swelling rate data, where the cell storage swelling rate model represents a correspondence between the cell storage time and the cell swelling rate. In this embodiment of this application, the cell cycling swelling rate data of the battery corresponding to the cycling operating condition parameter set and the cell storage swelling rate data corresponding to the storage operating condition parameter set are collected, and the cell cycling swelling rate model and the cell storage swelling rate model can be established according to the collected data.

In an embodiment of this application, the cycling operating condition parameter set includes multiple cycling operating condition parameter groups; each cycling operating condition parameter group includes multiple first parameter items; the multiple first parameter items include a cycling parameter and at least one another parameter; values of a same first parameter item in different cycling operating condition parameter groups are not all the same; and each cycling operating condition parameter group corresponds to one group of cell cycling swelling rate data. The storage operating condition parameter set includes multiple storage operating condition parameter groups; each storage operating condition parameter group includes multiple second parameter items; the multiple second parameter items include a storage parameter and at least one another parameter; values of a same second parameter item in different storage operating condition parameter groups are not all the same; and each storage operating condition parameter group corresponds to one group of cell storage swelling rate data. In this embodiment of this application, limitations are imposed on the cycling operating condition parameter set and the storage operating condition parameter set. Since the values of the same first parameter item in different cycling operating condition parameter groups are not all the same, cell cycling swelling rate data corresponding to different cycling operating condition parameters can be obtained. Since the values of the same second parameter item in different storage operating condition parameter groups are not all the same, cell storage swelling rate data corresponding to different storage operating condition parameters can be obtained.

In an embodiment of this application, the cell cycling swelling rate data is obtained by fitting electrode plate cycling swelling rate data and gas cycling swelling rate data, and the cell storage swelling rate data is obtained by fitting electrode plate storage swelling rate data and gas storage swelling rate data. In this embodiment of this application, electrode plate swelling and gas swelling present in the battery are considered in both the processes of establishing the cell cycling swelling rate model and the cell storage swelling rate model, thereby ensuring the accuracy of the established battery swelling rate model of the battery.

A second aspect of this application provides an electrochemical apparatus including a processor and a machine-readable storage medium. A machine-executable instruction executable by the processor is stored in the machine-readable storage medium, and when the processor executes the machine-executable instruction, the method according to the first aspect is performed.

A third aspect of this application provides an electric device, where the electric device includes the electrochemical apparatus according to the second aspect.

Some embodiments of this application have the following beneficial effects.

Some embodiments of this application provide a method for predicting swelling and life of a battery, an electrochemical apparatus, and an electric device. With a battery operating condition parameter received, multiple battery swelling rate versus battery life distribution curves can be obtained, such that a life distribution of the battery corresponding to a preset battery swelling rate threshold can be obtained. Alternatively, a swelling rate distribution of the battery corresponding to a specified battery use time can be obtained based on the multiple battery swelling rate versus battery life distribution curves. In this way, the swelling and life of the battery are predicted.

Certainly, any one of the products or methods in these embodiments of this application does not necessarily need to simultaneously achieve all the advantages described above.

### BRIEF DESCRIPTION OF DRAWINGS

To describe the technical solutions in some embodiments of this application more clearly, the following briefly describes the accompanying drawings required for describing some embodiments. Apparently, the accompanying drawings in the following descriptions show some embodiments of this application, and persons of ordinary skill in the art may still derive others drawings from these accompanying drawings.
FIG. 1 is a flowchart of a first method for predicting swelling and life of a battery according to an embodiment of this application;
FIG. 2 is a schematic diagram of a battery swelling rate model according to an embodiment of this application;
FIG. 3 is a flowchart of a second method for predicting swelling and life of a battery according to an embodiment of this application;
FIG. 4 is a flowchart of a third method for predicting swelling and life of a battery according to an embodiment of this application;
FIG. 5 is a schematic curve fitting diagram showing coaction of electrode plate swelling and gas swelling according to an embodiment of this application;
FIG. 6 is a flowchart of a fourth method for predicting swelling and life of a battery according to an embodiment of this application;
FIG. 7 is a schematic diagram of a relationship between coefficient a and temperature T in an initial swelling rate model of a cell according to an embodiment of this application;
FIG. 8 is a schematic diagram of calculation of cumulative damage of a battery according to an embodiment of this application;
FIG. 9 is a flowchart of a fifth method for predicting swelling and life of a battery according to an embodiment of this application;
FIG. 10 is a schematic structural diagram of an electrochemical apparatus according to an embodiment of this application; and
FIG. 11 is a schematic diagram of a battery swelling rate model containing relevant input parameters according to an embodiment of this application.

### DESCRIPTION OF EMBODIMENTS

The following clearly describes in detail the technical solutions in some embodiments of this application with reference to the accompanying drawings in some embodiments of this application. Apparently, the described embodiments are only some rather than all embodiments of this application. All other embodiments obtained by persons of ordinary skill in the art based on some embodiments of this application shall fall within the protection scope of this application.

The inventors of this application have found in a process of implementing this application that, in the prior art, a sensor is generally used to detect swelling information of a battery to determine swelling situation of the battery, or relevant parameters of the battery during use are monitored to determine the swelling situation of the battery. With use of these methods, only the current swelling situation of the battery can be analyzed and determined, and a swelling rate of the battery in a future time cannot be predicted, or the life or quantity of cycles of the battery when the battery reaches a preset swelling rate cannot be predicted.

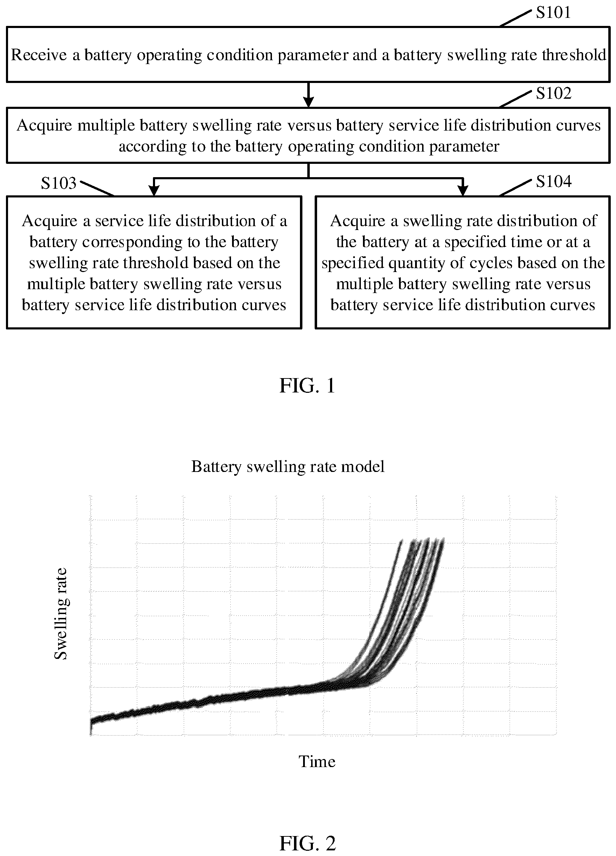

In view of this, some embodiments of this application provide a method for predicting swelling and life of a battery. FIG. 1 is a flowchart of a method for predicting swelling and life of a battery according to an embodiment of this application. The method includes the following steps.

Step S101. Receive a battery operating condition parameter and a battery swelling rate threshold.

The battery operating condition parameter represents an operating related parameter of a battery. In an example, the battery operating condition parameter includes: temperature, charge cut-off voltage, discharge cut-off voltage, charge rate, discharge rate, quantity of battery continuous cycles per day, storage voltage, and storage time. The temperature may be a temperature of an environment in which the battery is located or a temperature of the battery. The quantity of battery continuous cycles per day is a quantity of cycles in which the battery is discharged from the charge cut-off voltage to the discharge cut-off voltage and then charged to the charge cut-off voltage in each day, where the battery being discharged from the charge cut-off voltage to the discharge cut-off voltage and then charged to the charge cut-off voltage is one continuous cycle; and the battery swelling rate threshold is a maximum swelling rate allowable by the battery. The battery swelling rate threshold may be customized according to actual conditions, and when a swelling rate of the battery is greater than the battery swelling rate threshold, the risks associated with continued use of the battery significantly increase.

Step S102. Acquire multiple battery swelling rate versus battery life distribution curves according to the battery operating condition parameter.

Different battery operating condition parameters correspond to different distribution curves. One battery operating condition parameter group corresponds to multiple distribution curves. Acquiring the distribution curves corresponding to the battery operating condition parameter means acquiring multiple battery swelling rate versus battery life distribution curves according to the battery operating condition parameter.

In an example, a battery swelling rate model may be established for describing variation of a swelling rate of the battery with use time of the battery. Specifically, the battery swelling rate model represents: a family of curves depicting battery swelling rate versus battery life distribution curves corresponding to different battery operating condition parameters. For each curve constituting the foregoing family of curves, an independent variable of this curve is the use time of the battery, and a dependent variable is the swelling rate of the battery. Moreover, undetermined parameters in a function relation describing this curve are related to the battery operating condition parameter. Therefore, after the battery operating condition parameter is received, an actual function relation for each curve in the foregoing family of curves corresponding to the foregoing battery operating condition parameter can be determined. Thus, a battery swelling rate model corresponding to the foregoing battery operating condition parameter is determined. In addition, the independent variable of each curve in the foregoing family of curves is the use time of the battery and the dependent variable is the swelling rate of the battery. Therefore, after the battery swelling rate threshold is received, for each curve in the foregoing family of curves, the use time of the battery corresponding to the battery swelling rate threshold in this curve can be obtained.

It can be learned from the foregoing description that after the battery operating condition parameter is received, a family of curves formed by multiple battery swelling rate versus battery life distribution curves corresponding to the foregoing battery operating condition parameter can be determined. As shown in FIG. 2, the independent variable of each curve in the family of curves is time, that is, the use time of the battery; and the dependent variable is a swelling rate, that is, the swelling rate of the battery. Therefore, after the battery operating condition parameter is received, the multiple battery swelling rate versus battery life distribution curves can be acquired, where the life of the battery is represented by time or a quantity of cycles, the time refers to the use time of the battery, and the quantity of cycles refers to a total quantity of cycles of the battery. It can be understood that a parameter in the horizontal axis in FIG. 2 is time and can be replaced with the quantity of cycles.

Step S103. Acquire a life distribution of the battery corresponding to the battery swelling rate threshold based on the multiple battery swelling rate versus battery life distribution curves.

Specifically, the life of the battery corresponding to the battery swelling rate threshold can be obtained according to each distribution curve representing the swelling rate of the battery versus the life of the battery. For a same swelling rate of the battery, the foregoing each distribution curve representing the swelling rate of the battery versus the life of the battery corresponds to a different life of the battery. Therefore, multiple values of the life of the battery can be obtained based on the multiple battery swelling rate versus battery life distribution curves, and the life distribution of the battery can be obtained through statistic analysis on the multiple values of the life of the battery.

Or, step S104. Acquire a swelling rate distribution of the battery at a specified time or at a specified quantity of cycles based on the multiple battery swelling rate versus battery life distribution curves.

Specifically, for a given battery, without considering variation of battery performance with time, a time required for the battery to be discharged from the charge cut-off voltage to the discharge cut-off voltage and then charged to the charge cut-off voltage is constant. The quantity of cycles represents the quantity of battery continuous cycles per day. Therefore, under a condition that the quantity of cycles is obtained, the time required for the battery to complete charge and discharge cycles corresponding to the quantity of cycles can be determined. The use time of the battery includes the storage time and the time required for the battery to complete the charge and discharge cycles, where the storage time is a known variable. Therefore, under a condition that the time required for the battery to complete the charge and discharge cycles corresponding to the quantity of cycles is determined based on the quantity of cycles, the use time of the battery can be determined.

A swelling rate of the battery corresponding to a specified use time of the battery can be obtained according to each distribution curve representing the swelling rate of the battery versus the life of the battery. With a same use time of the battery, the foregoing each distribution curve representing the swelling rate of the battery versus the life of the battery corresponds to a different swelling rate of the battery. Therefore, multiple values of the swelling rate of the battery can be obtained based on the multiple battery swelling rate versus battery life distribution curves, and a swelling rate distribution of the battery at a specified time or at a specified quantity of cycles can be obtained through statistic analysis on the multiple values of the swelling rate of the battery, where the specified time refers to the use time of the battery.

According to the method for predicting swelling and life of a battery in this embodiment of this application, multiple battery swelling rate versus battery life distribution curves can be obtained by receiving the battery operating condition parameter, so that a life distribution of the battery corresponding to a preset battery swelling rate threshold can be obtained, and a swelling rate distribution of the battery corresponding to a specified use time of the battery can also be obtained based on the multiple battery swelling rate versus battery life distribution curves, and thus swelling and life of the battery are predicted.

In an embodiment of this application, after the foregoing step S103, the following step E is further included; and after the foregoing step S104, the following step F is further included.

Step E. Acquire a life of the battery corresponding to the battery swelling rate threshold.

Specifically, the life distribution of the battery is obtained in the foregoing step S103, where the life distribution of the battery includes multiple values of the life of the battery, and the multiple values include a maximum value and a minimum value. Therefore, a specific value can be determined based on the life distribution of the battery as the life of the battery corresponding to the battery swelling rate threshold, and this battery life is represented by a time extremum corresponding to the battery swelling rate threshold or represented by a time average corresponding to the battery swelling rate threshold. The time extremum may be the maximum value or the minimum value, and the time average is an arithmetic mean value of all the values of the life of the battery included in the life distribution of the battery.

Step F. Acquire a swelling rate of the battery.

Specifically, the swelling rate distribution of the battery is obtained in the foregoing step S104, and the swelling rate distribution of the battery includes multiple values of the swelling rate of the battery. Therefore, a specific value can be determined based on the swelling rate distribution of the battery as the swelling rate of the battery in a specified time or at a specified quantity of cycles, and this battery swelling rate is represented by a swelling rate extremum of the battery at the specified time or at the specified quantity of cycles or represented by a swelling rate average of the battery at the specified time or at the specified quantity of cycles. The swelling rate extremum may be a maximum value or a minimum value in the multiple values of the swelling rate of the battery included in the swelling rate distribution of the battery, and the swelling rate average is an arithmetic mean value of all the values of the swelling rate of the battery included in the swelling rate distribution of the battery.

In this embodiment of this application, based on the multiple battery swelling rate versus battery life distribution curves, the life of the battery corresponding to the preset battery swelling rate threshold can be acquired, or the swelling rate of the battery in a specified time or at a specified quantity of cycles can be acquired.

In an embodiment of this application, the foregoing step S102 may be implemented through the following step G.

Step G. Input the battery operating condition parameter into a battery swelling rate model to obtain multiple battery swelling rate versus battery life distribution curves.

Specifically, the battery swelling rate model in step G is the battery swelling rate model as described above. After the battery operating condition parameter is received, the battery operating condition parameter is inputted into the battery swelling rate model, and then multiple battery swelling rate versus battery life distribution curves can be obtained.

In an embodiment of this application, the temperature is represented by geographical location data, that is, the geographical location is associated with temperature data of a corresponding location each day. The foregoing step G may be implemented through the following step G1.

Step G1. Input the geographical location data, the charge cut-off voltage, the discharge cut-off voltage, the charge rate, the discharge rate, and the quantity of battery continuous cycles per day into the battery swelling rate model to obtain multiple battery swelling rate versus battery life distribution curves.

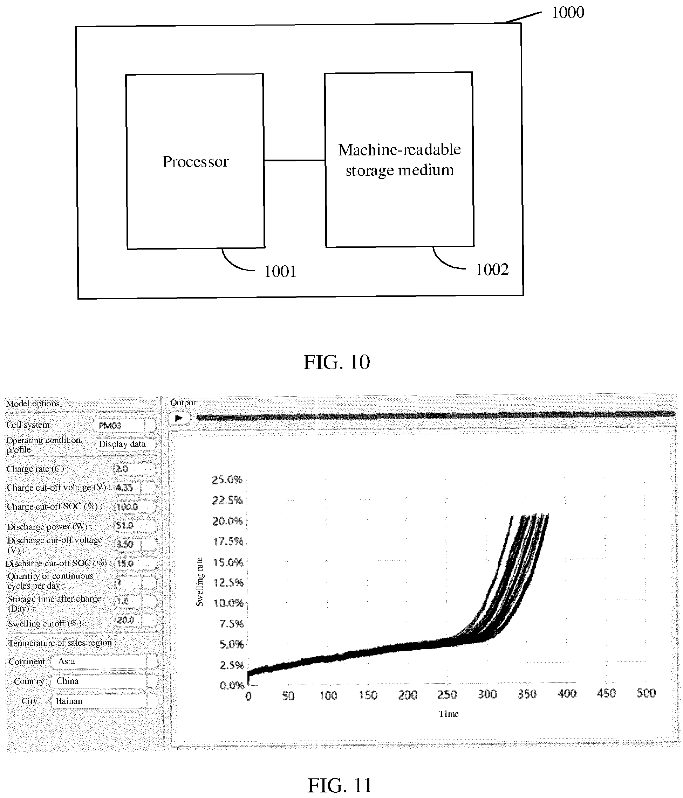

Specifically, FIG. 11 is a schematic diagram of a battery swelling rate model containing relevant input parameters according to an embodiment of this application. The geographical location data is associated with temperature data of a corresponding location each day. Therefore, as shown in FIG. 11, a temperature of Hainan province can be obtained by inputting "Asia", "China", and "Hainan" at items corresponding to "Continent", "Country", and "City", and this temperature is used as a value of the temperature in the battery operating condition parameter. Certainly, names of other regions may also be inputted to obtain corresponding temperatures of the regions, and these temperatures are used as values of the temperature in the battery operating condition parameter. The parameter in FIG. 11 further includes a cell system, charge rate, charge cut-off voltage, charge cut-off SOC, discharge power, discharge cut-off voltage, discharge cut-off SOC, quantity of continuous cycles per day, storage time after charge, and Swelling cutoff, where the Swelling cutoff is the swelling rate of the battery, the charge cut-off SOC is directly proportional to the charge cut-off voltage, the discharge cut-off SOC is directly proportional to discharge cut-off voltage, the discharge power is directly proportional to the discharge rate, and the discharge power can be calculated from the discharge rate.

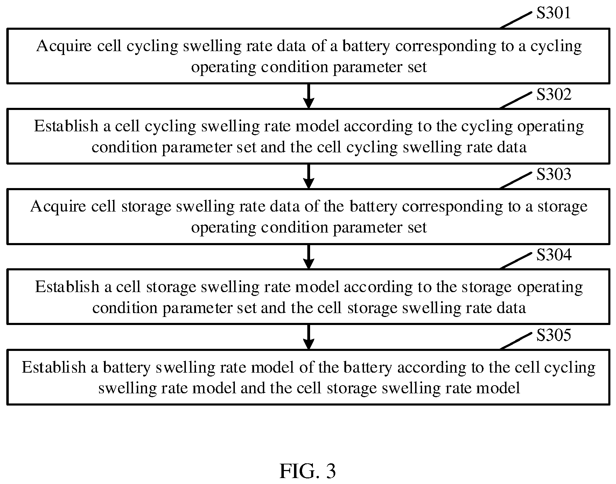

The battery swelling rate model may be obtained using a method as shown in FIG. 3. FIG. 3 is a flowchart of a second method for predicting swelling and life of a battery according to an embodiment of this application, and the method includes the following steps.

Step S301. Acquire cell cycling swelling rate data of the battery corresponding to a cycling operating condition parameter set.

During actual application, the battery includes one or more cells. Swelling situations of the cells in the battery may be different, so the swelling situation of each cell in the battery needs to be analyzed as a reference for a swelling situation of the battery. During actual use of the battery, the battery may be in a charge state or a discharge state. In this case, any cell in the battery is also in a charge state or a discharge state, and a cell swelling rate changes in the charge state and discharge state of the cell. Therefore, a swelling rate variation of the cell needs to be analyzed in the charge state and discharge state of the cell. In this embodiment of this application, a set of relevant parameters of the cell related to the charge state and discharge state of the cell is referred to as a cycling operating condition parameter set. The cycling operating condition parameter set contains the temperature, the charge cut-off voltage, the discharge cut-off voltage, the charge rate, the discharge rate, and the quantity of continuous cycles in the foregoing step S101. A cell swelling rate in a state shown by the cycling operating condition parameter set is acquired through a test, and thus cell cycling swelling rate data of the battery corresponding to the cycling operating condition parameter set is obtained.

Step S302. Establish a cell cycling swelling rate model according to the cycling operating condition parameter set and the cell cycling swelling rate data.

The cell cycling swelling rate model represents a correspondence between the quantity of cell cycles and the cell swelling rate. Specifically, the quantity of continuous cycles is a quantity of cycles in which the cell is discharged from the charge cut-off voltage to the discharge cut-off voltage and then charged to the charge cut-off voltage.

For each cell, a cell swelling rate of the cell in a state shown by the cycling operating condition parameter set is a dependent variable, and the quantity of cell cycles is an independent variable. Specifically, in the state shown by the cycling operating condition parameter set, multiple cell swelling rates of the cell are obtained, respectively corresponding to multiple quantities of cell cycles. Therefore, a cell cycling swelling rate model can be established according to the multiple cell swelling rates and the multiple quantities of cell cycles. For example, the cell cycling swelling rate model established is: y=a*f₁(x)+b*f₂(x)+c*f₃(x)+..., where x represents the quantity of cell cycles, y represents the cell swelling rate, a, b, c, and the like represent coefficients, and "*" represents multiplication.

Step S303. Acquire cell storage swelling rate data of the battery corresponding to a storage operating condition parameter set.

During actual use of the battery, if the battery is not in a charge state or a discharge state, the battery is considered to be in a storage state. Correspondingly, under a condition that the battery is in the storage state, any cell in the battery is in a storage state. The cell swelling rate changes in its storage state. Therefore, a swelling rate variation of the cell in the storage state needs to be analyzed. In this embodiment of this application, a set of relevant parameters of the cell related to the storage state of the cell is referred to as a storage operating condition parameter set. The storage operating condition parameter set includes the temperature, the storage voltage, and the storage time in the foregoing step S101, where the storage voltage refers to a voltage of the battery in the storage state, and the storage time refers to a time for which the battery is in the storage state. A cell swelling rate in the state shown by the storage operating condition parameter set is acquired through a test, and thus cell storage swelling rate data of the battery is obtained corresponding to the storage operating condition parameter set.

Step S304. Establish a cell storage swelling rate model according to the storage operating condition parameter set and the cell storage swelling rate data.

The cell storage swelling rate model represents a correspondence between the cell storage time and the cell swelling rate. Specifically, the cell storage time refers to a time for which the cell is in the storage state.

For each cell in the battery, a swelling rate of this cell in the state shown by the storage operating condition parameter set is a dependent variable, and the cell storage time is an independent variable. Specifically, in the state shown by the storage operating condition parameter set, multiple cell swelling rates of the cell are obtained, respectively corresponding to multiple cell storage times. Therefore, a cell storage swelling rate model can be established according to the multiple cell swelling rates and the multiple cell storage times. For example, the cell storage swelling rate model established is: y=a*f₁(x)+b*f₂(x)+c*f₃(x)+..., where x represents the cell storage time, y represents the cell swelling rate, a, b, c, and the like represent coefficients, and "*" represents multiplication.

Step S305. Establish a battery swelling rate model of the battery according to the cell cycling swelling rate model and the cell storage swelling rate model.

Various states such as a charge state, a discharge state, and a storage state of the cell all affect the cell swelling rate, the cell cycling swelling rate model describes influence of the charge state and discharge state of the cell on the cell swelling rate, the cell storage swelling rate model describes influence of the storage state of the cell on the cell swelling rate, and the swelling rate of the battery can be embodied by the swelling rate of the cell included in the battery. Therefore, a battery swelling rate model of the battery can be established by comprehensive assessment of influence on the cell swelling rate according to the cell cycling swelling rate model and the cell storage swelling rate model. Specifically, the battery swelling rate model represents a correspondence between the use time of the battery and the swelling rate of the battery. For example, the battery swelling rate model established is: a*f₁(x)+b*f₂(x)+c*f₃(x)+..., where x represents the use time of the battery, y represents the swelling rate of the battery, a, b, c, and the like represent coefficients, and "*" represents multiplication.

Operating conditions of the battery include a cycling operating condition under which charge and discharge processes are included and a storage operating condition under which charge and discharge processes are not included. Therefore, in this embodiment of this application, the cell cycling swelling rate data of the battery corresponding to the cycling operating condition parameter set and the cell storage swelling rate data of the battery corresponding to the storage operating condition parameter set are acquired, and the cell cycling swelling rate model and the cell storage swelling rate model can be established according to the data acquired, and then the battery swelling rate model can be established based on a combination of the cell cycling swelling rate model and the cell storage swelling rate model. In this way, the swelling and life of the battery under a given condition can be predicted based on the battery swelling rate model.

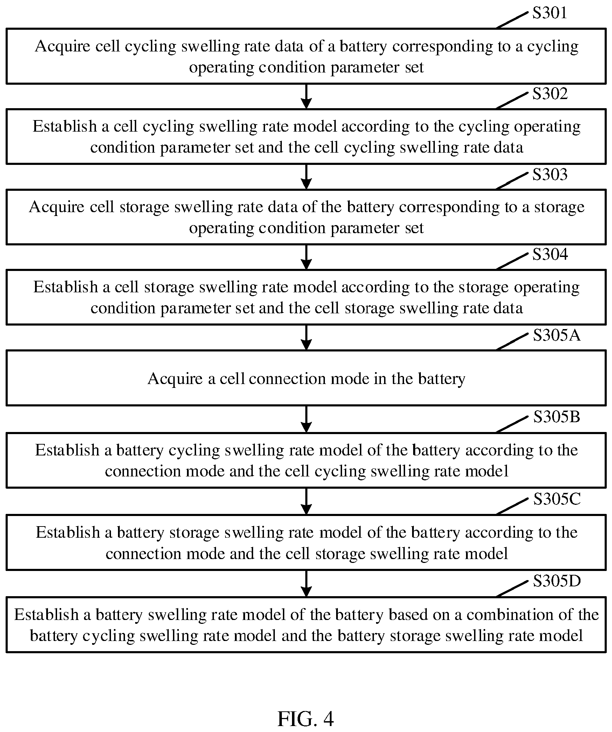

In an embodiment of this application, the foregoing step S305 may be implemented through the following steps S305A to S305D. FIG. 4 is a flowchart of a third method for predicting swelling and life of a battery according to this embodiment of this application. As compared with FIG. 3, step S305 is implemented through the following steps.

Step S305A. Acquire a cell connection mode in the battery.

Specifically, the cell connection mode in the battery may be different connection modes such as serial connection and parallel connection of multiple cells, and a specific cell connection mode in the battery needs to be considered during establishment of a battery swelling rate model.

Step S305B. Establish a battery cycling swelling rate model according to the connection mode and the cell cycling swelling rate model.

After the cell connection mode in the battery is acquired, a battery cycling swelling rate model of the battery is obtained based on the cell cycling swelling rate model according to the cell connection mode in the battery.

Step S305C. Establish a battery storage swelling rate model of the battery according to the connection mode and the cell storage swelling rate model.

After the cell connection mode in the battery is acquired, a battery storage swelling rate model of the battery is obtained based on the cell storage swelling rate model according to the cell connection mode in the battery.

Step S305D. Establish a battery swelling rate model of the battery based on a combination of the battery cycling swelling rate model and the battery storage swelling rate model.

Specifically, the battery cycling swelling rate model describes influence of a charge state and a discharge state of the battery on the swelling rate of the battery, the battery storage swelling rate model describes influence of a storage state of the battery on the swelling rate of the battery, and the battery swelling rate model established based on the combination of the battery cycling swelling rate model and the battery storage swelling rate model can comprehensively describes a relationship between the swelling rate of the battery and the use time of the battery.

In this embodiment of this application, in the process of establishing the battery swelling rate model, the cell connection mode in the battery is considered, which can implement establishment of battery swelling rate models of batteries adopting different cell connection modes.

In an embodiment of this application, the cycling operating condition parameter set includes multiple cycling operating condition parameter groups. Each cycling operating condition parameter group includes multiple first parameter items. The multiple first parameter items include a cycling parameter and at least one another parameter. Values of a same first parameter item in different cycling operating condition parameter groups are not all the same. Each cycling operating condition parameter group corresponds to one group of cell cycling swelling rate data.

Specifically, the following Table 1 shows the cycling operating condition parameter set.

**Table 1**

| Parameter | Temperature | Charge cut-off voltage | Discharge cut-off voltage | Charge rate/discharge rate | Quantity of continuous cycles | Quantity of samples |
|---|---|---|---|---|---|---|
| 1 | T₁ | V_{C1} | V_{D1} | C_{C1}/C_{D1} | m₁ | n |
| 2 | T₂ | V_{C1} | V_{D1} | C_{C1}/C_{D1} | m₂ | n |
| 3 | T₃ | V_{C1} | V_{D1} | C_{C1}/C_{D1} | m₃ | n |
| ... | ... | ... | ... | ... | ... | ... |

Table 1 shows an example of the cycling operating condition parameter set. The "Quantity of samples" in Table 1 refers to a quantity of cell samples for test under this cycling operating condition, and the "Quantity of continuous cycles" refers to the quantity of cycles in which the battery is discharged from the charge cut-off voltage to the discharge cut-off voltage and then charged to the charge cut-off voltage.

It can be seen from Table 1 that three cycling operating condition parameter groups are shown in Table 1, and the first parameter items refer to the temperature, the charge cut-off voltage, the discharge cut-off voltage, the charge rate, the discharge rate, and the quantity of continuous cycles in Table 1.

The storage operating condition parameter set includes multiple storage operating condition parameter groups. Each storage operating condition parameter group includes multiple second parameter items. the multiple second parameter items include a storage parameter and at least one another parameter. Values of the same second parameter item in different storage operating condition parameter groups are not all the same. Each storage operating condition parameter group corresponds to one group of cell storage swelling rate data.

Specifically, the following Table 2 shows the storage operating condition parameter set.

**Table 2**

| Parameter | Temperature | Storage voltage | Storage time | Quantity of samples |
|---|---|---|---|---|
| 1 | T₁ | Vₛ₁ | t₁ | n |
| 2 | T₁ | Vₛ₂ | t₂ | n |
| 3 | T₂ | Vₛ₁ | t₃ | n |
| ... | ... | ... | ... | ... |

Table 2 shows an example of the storage operating condition parameter set. The "Quantity of samples" in Table 2 refers to a quantity of cell samples for test under this storage operating condition.

It can be seen from Table 2 that three storage operating condition parameter groups are shown in Table 2, and the second parameter items included in each storage operating condition parameter group refer to the temperature, the storage voltage, and the storage time in Table 2.

In this embodiment of this application, limitations are imposed on the cycling operating condition parameter set and the storage operating condition parameter set. Since the values of the same first parameter item in different cycling operating condition parameter groups are not all the same, cell cycling swelling rate data corresponding to different cycling operating condition parameters can be obtained. Since the values of the same second parameter item in different storage operating condition parameter groups are not all the same, cell storage swelling rate data corresponding to different storage operating condition parameters can be obtained.

In an embodiment of this application, the cell cycling swelling rate data is obtained through an actual test, and a corresponding function expression can be obtained through fitting. The cell storage swelling rate data is obtained through an actual test, and a corresponding function expression can be obtained through fitting.

Specifically, under a condition that the cell is in any of the charge state, the discharge state, and the storage state, swelling of the cell can be considered as a result of coaction of electrode plate swelling and gas swelling, where the electrode plate swelling refers to swelling produced by an electrode plate of the cell, and the gas swelling refers to swelling produced by gas production in the cell. Therefore, the swelling of the cell can be expressed as superposition of electrode plate swelling and gas swelling. The electrode plate cycling swelling rate corresponds to electrode plate swelling of the cell in a state shown by the cycling operating condition parameter set, and the gas cycling swelling rate corresponds to gas swelling of the cell in a state shown by the cycling operating condition parameter set. The electrode plate storage swelling rate corresponds to electrode plate swelling of the cell in a state shown by the storage operating condition parameter set, and the gas storage swelling rate corresponds to gas swelling of the cell in a state shown by the storage operating condition parameter set.

The cell cycling swelling rate data and the cell storage swelling rate data are both obtained under coaction of electrode plate swelling and gas swelling, and a manner of obtaining the function expression of the cell cycling swelling rate or the function expression of the cell storage swelling rate through fitting may be shown in FIG. 3.

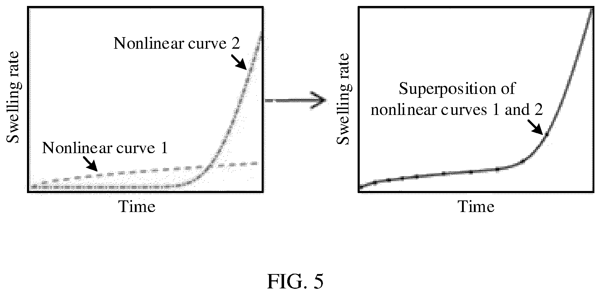

FIG. 5 is a schematic curve fitting diagram showing coaction of electrode plate swelling and gas swelling. In FIG. 5, a nonlinear curve 1 is a curve describing electrode plate swelling, a nonlinear curve 2 is a curve describing gas swelling, the nonlinear curve 1 and the nonlinear curve 2 can be subjected to nonlinear curve superposition to obtain a curve indicated by "superposition of nonlinear curves 1 and 2" in FIG. 5, that is, a schematic diagram of a curve formed by the cell cycling swelling rate data or the cell storage swelling rate data.

For example, the nonlinear curve 1 may be represented as y₁=f(x), the nonlinear curve 2 may be represented as y₂=g(x), and the curve indicated by "superposition of nonlinear curves 1 and 2" may be represented as y=f(x)+g(x)=a*f₁(x)+b*f₂(x)+c*f₃(x)+..., where a, b, c, and the like represent coefficients, and "*" represents multiplication.

In this embodiment of this application, electrode plate swelling and gas swelling present in the battery are considered in both the processes of establishing the cell cycling swelling rate model and the cell storage swelling rate model, thereby ensuring the accuracy of the established battery swelling rate model of the battery.

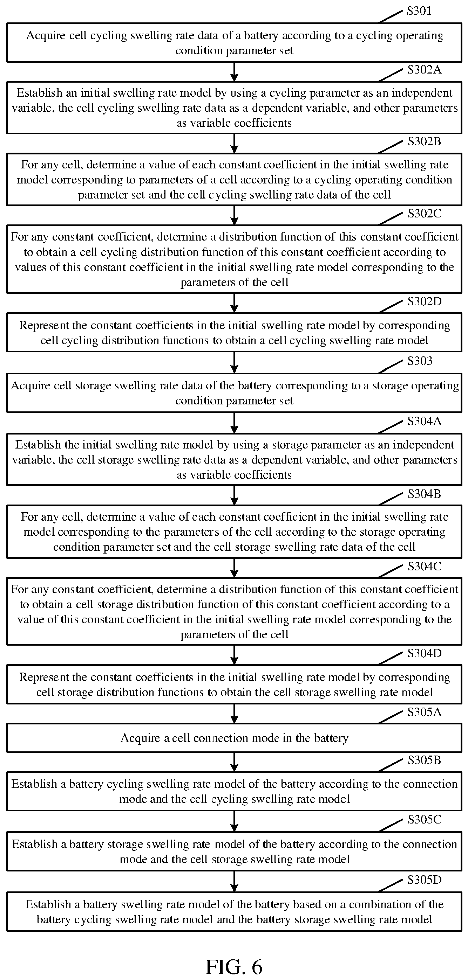

In an embodiment of this application, FIG. 6 is a flowchart of a fourth method for predicting swelling and life of a battery according to this embodiment of this application. As compared with FIG. 4, step S302 may be implemented through the following steps S302A to S302D, and step S304 may be implemented through the following steps S304A to S304D.

Step S302A. Establish an initial swelling rate model by using a cycling parameter as an independent variable, the cell cycling swelling rate data as a dependent variable, and other parameters as variable coefficients.

The initial swelling rate model includes multiple independent variable function items. The independent variable function items include independent variable functions and function coefficients. The function coefficients include variable coefficients and constant coefficients, with each variable coefficient corresponding to one constant coefficient.

Specifically, the cycling parameter refers to the quantity of continuous cycles in Table 1, and the other parameters refer to the temperature, the charge cut-off voltage, the discharge cut-off voltage, the charge rate, and the discharge rate in Table 1. For example, the initial swelling rate model may be represented as y=a*f₁(x)+b*f₂(x)+c*f₃(x)+...=A*fₐ(T,V)*f₁(x)+B*f_{b}(T,V)*f₂(x)+C*f_{c}(T,V)*f₃(x)+...; where x represents the quantity of continuous cycles; y represents the cell swelling rate; "*" represents multiplication; A*fₐ(T,V)*f₁(x), B*f_{b}(T,V)*f₂(x), C*f_{c}(T,V)*f₃(x), and the like represent the independent variable function items; fₐ(T,V), f_{b}(T,V), f_{c}(T,V), and the like represent the variable coefficients; A, B, C, and the like represent the constant coefficients; T represents the temperature; and V represents the charge cut-off voltage or the discharge cut-off voltage. For example, fₐ(T,V) is just an expression manner and does not mean that the variable coefficients in the initial swelling rate model are related to only the temperature, the charge cut-off voltage, or the discharge cut-off voltage.

Step S302B. For any cell, determine a value of each constant coefficient in the initial swelling rate model corresponding to the parameters of the cell according to the cycling operating condition parameter set and the cell cycling swelling rate data of the cell.

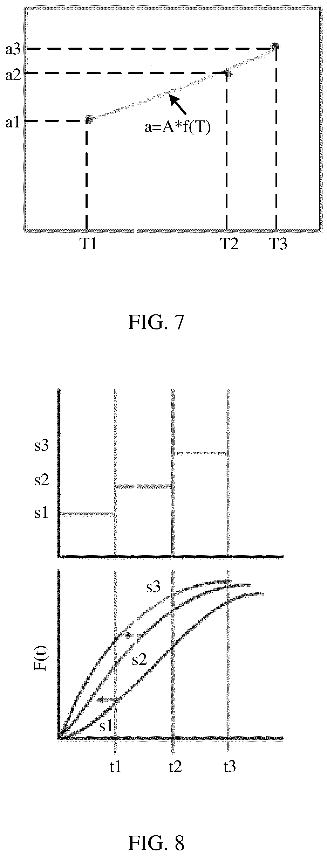

For example, for any cell in the battery, to obtain a relationship between a and temperature T in the initial swelling rate model of the cell, for the multiple cycling operating condition parameter groups included in the cycling operating condition parameter set, only values of temperatures T in all the cycling operating condition parameter groups are made different, and data in the cycling operating condition parameter set is inputted into the initial swelling rate model of the cell, such that multiple values of a can be obtained, where each value of a corresponds to one value of T. In this way, a relational expression between a and T can be established as: a=A*f(T), where "*" represents multiplication, and a schematic diagram of the rational expression may be shown in FIG. 7. A value of A in the initial swelling rate model can be obtained by fitting of a curve shown in FIG. 7. A value of each constant coefficient in the initial swelling rate model corresponding to the parameters of the cell can be obtained in a same manner.

Step S302C. For any constant coefficient, determine a distribution function of this constant coefficient to obtain a cell cycling distribution function of this constant coefficient according to values of this constant coefficient in the initial swelling rate model corresponding to the parameters of the cell.

Each cell in the test is subjected to an operation shown in the foregoing step S302B. Therefore, under a condition that the quantity of cell samples in the test is n, for one cell i, corresponding Aᵢ, Bᵢ, Cᵢ, ..., and the like can be obtained, where i represents a corresponding number of the cell, and i takes a value from 1, 2, 3, ..., and n. For example, the obtained n values of A₁, A₂, ..., and Aₙ are subjected to statistic analysis to obtain distribution (µ1, δ1), referred to as distribution (µ1, δ1) that A follows in the initial swelling rate model. Distributions that B, C, ..., and the like in the initial swelling rate model follow respectively can be obtained in a same manner, and the distributions that A, B, C, ..., and the like follow respectively are referred to as cell cycling distribution functions corresponding to the constant coefficients.

Step S302D. Represent the constant coefficients in the initial swelling rate model by corresponding cell cycling distribution functions to obtain the cell cycling swelling rate model.

The cell cycling distribution functions corresponding to the constant coefficients and obtained in the foregoing step S302C are substituted into the initial swelling rate model, to be specific, the constant coefficients in the initial swelling rate model are substituted, where the model in which the constant coefficients are substituted is referred to as the cell cycling swelling rate model.

Step S304A. Establish the initial swelling rate model by using a storage parameter as an independent variable, the cell storage swelling rate data as a dependent variable, and other parameters as variable coefficients.

The initial swelling rate model includes multiple independent variable function items. The independent variable function items include an independent variable function and function coefficients. The function coefficients include variable coefficients and constant coefficients, with each variable coefficient corresponding to one constant coefficient.

Specifically, the storage parameter refers to the storage time in Table 2, and the other parameters refer to the temperature and storage voltage in Table 2. For example, the initial swelling rate model may be represented as y=a*f₁(x)+b*f₂(x)+c*f₃(x)+...=A*fₐ(T,V)*f₁(x)+B*f_{b}(T,V)*f₂(x)+C*f_{c}(T,V)*f₃(x)+...; where x represents the storage time; y represents the cell swelling rate; "*" represents multiplication; A*fₐ(T,V)*f₁(x), B*f_{b}(T,V)*f₂(x), C*f_{c}(T,V)*f₃(x), and the like represent the independent variable function items; fₐ(T,V), f_{b}(T,V), f_{c}(T,V), and the like represent the variable coefficients; A, B, C, and the like represent the constant coefficients; T represents the temperature; and V represents the storage voltage.

Step S304B. For any cell, determine a value of each constant coefficient in the initial swelling rate model corresponding to the parameters of the cell according to the storage operating condition parameter set and the cell storage swelling rate data of the cell.

For example, for any cell in the test, to obtain a relationship between a and temperature T in the initial swelling rate model of the cell under a storage operating condition, for the multiple storage operating condition parameter groups included in the storage operating condition parameter set, only values of temperatures T in all the storage operating condition parameter groups are different, and data in the storage operating condition parameter set is inputted into the initial swelling rate model of the cell, such that multiple values of a can be obtained, where each value of a corresponds to one value of T. In this way, a relational expression between a and T can be established as: a=A*f(T), where "*" represents multiplication, and because the values of a and T are known, a value of A can be obtained. A value of each constant coefficient in the initial swelling rate model of the cell under the storage operating condition can be obtained in a same manner.

Step S304C. For any constant coefficient, determine a distribution function of this constant coefficient to obtain a cell storage distribution function of this constant coefficient according to values of this constant coefficient in the initial swelling rate model corresponding to the parameters of the cell.

Each cell in the test is subjected to an operation shown in the foregoing step S304B. Therefore, under a condition that the quantity of cell samples in the test is n, for one cell i, corresponding Aᵢ, Bᵢ, Cᵢ, ..., and the like can be obtained, where i represents a corresponding number of the cell, and i takes a value from 1, 2, 3, ..., and n. For example, the obtained n values of A₁, A₂, ..., and Aₙ are subjected to statistic analysis to obtain distribution (µ2, δ2), referred to as distribution (µ2, δ2) that A follows in the initial swelling rate model under the storage operating condition. Distributions that B, C, ..., and the like in the initial swelling rate model follow respectively can be obtained in a same manner, and the distributions that A, B, C, ..., and the like follow respectively are referred to as cell storage distribution functions corresponding to the constant coefficients.

Step S304D. Represent the constant coefficients in the initial swelling rate model by corresponding cell storage distribution functions to obtain the cell storage swelling rate model.

The cell storage distribution functions corresponding to the constant coefficients and obtained in the foregoing step S304C are substituted into the initial swelling rate model, to be specific, the constant coefficients in the initial swelling rate model are substituted, where the model in which the constant coefficients are substituted is referred to as the cell storage swelling rate model.

In the cell cycling swelling rate model established in this embodiment of this application, for any constant coefficient, the cell cycling distribution function of this constant coefficient represents a statistic of values of this constant coefficient in the initial swelling rate model corresponding to all cells in the battery, so the cell cycling swelling rate model can better reflect a swelling situation of the cell under the cycling operating condition. In the cell storage swelling rate model, for any constant coefficient, the cell storage distribution function of this constant coefficient represents a statistic of values of this constant coefficient in the initial swelling rate model corresponding to all cells in the battery, so the cell storage swelling rate model can better reflect a swelling situation of the cell under the storage operating condition.

In an embodiment of this application, as compared with FIG. 6, step S305B may be implemented through the following steps H to M, and step S305C may be implemented through the following steps N to S.

Step H. Determine a target quantity according to the foregoing connection mode.

The target quantity is related to the cell connection mode in the battery. For example, if the cell connection mode in the battery are that n cells are connected in series, the target quantity is n. When multiple groups of cells are connected in parallel in the battery, each group of cells are connected in series, so the whole battery is a set of multiple groups of cells connected in series, where a battery swelling rate model of each group of cells connected in series can be calculated, and then a battery swelling rate model of the whole battery is obtained using a simple superposition method.

Step I. For any constant coefficient in the cell cycling swelling rate model, select a first preset quantity of values satisfying the cell cycling distribution function of this constant coefficient to obtain a first preset quantity of first values of this constant coefficient.

The first preset quantity is greater than the target quantity.

For example, a constant coefficient A in the cell cycling swelling rate model follows the distribution (µ1, δ1), and a Monte Carlo method is used for randomly taking a value from (µ1, δ1) for 5000 times to obtain 5000 values of A, that is, the first preset quantity is 5000, and the 5000 values of A are referred to as first values of A. 5000 values of each of B, C, ..., and the like can be obtained in a same manner, that is, respective first values of B, C, ..., and the like are obtained.

Step J. Select the target quantity of first values from the first values of the constant coefficient and calculate a mean value to obtain a second value of the constant coefficient.

For example, the first values of the constant coefficient A represent 5000 values of A; and if the target quantity is n, n values of A are randomly obtained from the 5000 values, then an arithmetic mean value of the n values of A is calculated, and a result obtained is referred to as a second value of A.

Similarly, respective second values of B, C, ..., and the like can be obtained in the manner of obtaining the second value of A.

Step K. Repeat the step of selecting the target quantity of first values from the first values of a constant coefficient and calculating a mean value to obtain a second value of the constant coefficient until a second preset quantity of second values of the constant coefficient are obtained.

For example, when the second preset quantity is 1000, it means that step K is repeated 1000 times to obtain respective 1000 second values of A, B, C, ..., and the like.

Step L. Calculate a battery cycling distribution function of the second preset quantity of second values of the constant coefficient.

For example, for the constant coefficient A, after 1000 second values of A are obtained, the 1000 second values are subjected to statistic analysis to obtain distribution (µ3, δ3) that A follows, and the distribution (µ3, δ3) is referred to as a battery cycling distribution function of A. Respective corresponding battery cycling distribution functions of B, C, ..., and the like can be obtained in a same manner.

Step M. The constant coefficients in the cell cycling swelling rate model are represented by corresponding battery cycling distribution functions to obtain the battery cycling swelling rate model.

The battery cycling distribution functions corresponding to the constant coefficients and obtained in the foregoing step L are substituted into the cell cycling swelling rate model, to be specific, the cell cycling distribution functions in the cell cycling swelling rate model are substituted, where the model in which the cell cycling distribution functions are substituted is referred to as the battery cycling swelling rate model.

Step N. Determine a target quantity according to the foregoing connection mode.

Step O. For any constant coefficient in the cell storage swelling rate model, select a first preset quantity of values satisfying the cell storage distribution function of this constant coefficient to obtain a third preset quantity of third values of this constant coefficient.

The third preset quantity is greater than the target quantity.

Step P. Select the target quantity of third values from the third values of the constant coefficient and calculate a mean value to obtain a fourth value of the constant coefficient.

Step Q. Repeat the step of selecting the target quantity of third values from the third values of the constant coefficient and calculating a mean value to obtain a fourth value of the constant coefficient until a fourth preset quantity of fourth values of the constant coefficient are obtained.

Step R. Calculate a battery storage distribution function of the fourth preset quantity of fourth values of the constant coefficient.

Step S. Represent the constant coefficients in the cell storage swelling rate model by corresponding battery storage distribution functions to obtain the battery storage swelling rate model.

Specifically, the implementation of the foregoing steps N to S are similar to that of the foregoing steps H to M, which are not repeated herein.

In this embodiment of this application, on the basis of the cell cycling distribution function of any constant coefficient in the cell cycling swelling rate model, the battery cycling distribution function of the constant coefficient is obtained through statistic analysis, such that the battery cycling distribution function is more similar to a distribution situation of a corresponding constant coefficient under an actual cycling operating condition of the battery. On the basis of the cell storage distribution function of any constant coefficient in the cell storage swelling rate model, the battery storage distribution function of the corresponding constant coefficient is obtained through statistic analysis, such that the battery storage distribution function is more similar to a distribution situation of the corresponding constant coefficient under an actual storage operating condition of the battery.

In an embodiment of this application, step S305D may be implemented through the following steps A to D.

Step A. Assign values to the constant coefficients in the battery cycling swelling rate model according to the battery cycling distribution functions of the constant coefficients in the battery cycling swelling rate model to obtain a parameterized battery cycling swelling rate model.

Specifically, values are randomly taken from the battery cycling distribution functions corresponding to A, B, C, ..., and the like in the battery cycling swelling rate model to obtain a group of coefficient values A1, B1, C1, ..., and the like; this group of coefficients are substituted into the battery cycling swelling rate model, that is, the battery cycling distribution function corresponding to A is substituted by A1, the battery cycling distribution function corresponding to B is substituted by B1, the rest can be done in the same manner, and the battery cycling distribution functions of the constant coefficients in the battery cycling swelling rate model are all substituted to obtain the parameterized battery cycling swelling rate model.

Step B. Assign values to the constant coefficients in the battery storage swelling rate model according to the battery storage distribution functions of the constant coefficients in the battery storage swelling rate model to obtain a parameterized battery storage swelling rate model.

Specifically, a manner of obtaining the parameterized battery storage swelling rate model is similar to the manner of obtaining the parameterized battery cycling swelling rate model in step A, which is not repeated herein.

Step C. Obtain a battery swelling prediction curve through calculation using a cumulative damage algorithm according to the parameterized battery cycling swelling rate model and the parameterized battery storage swelling rate model.

During actual use of the battery, damage of the battery is accumulated with the use time, cumulative damage of the battery needs to be considered in the process of establishing the battery swelling rate model, and a schematic diagram of calculation of the cumulative damage of the battery is shown in FIG. 8. In FIG. 8, t represents time, and S represents a stress level. A process for calculating the cumulative damage shown in FIG. 8 can be briefly described as follows.

Step 1. Calculate damage 1 of the battery at a stress level s1 and a time t1.

Step 2. Calculate damage 2 of the battery at a stress level s2 and a time t2 based on the damage 1.

Step 3. Calculate damage 3 of the battery at a stress level s3 and a time t3 based on the damage 2.

Other damages are calculated in the same manner, and the calculated damages are added to obtain a total damage of the battery.

Step D. Repeat the foregoing steps A to C until a third preset quantity of battery swelling prediction curves are obtained.

The battery swelling rate model includes the third preset quantity of battery swelling prediction curves.

For example, when the third preset quantity is n, it means that the foregoing step A and the foregoing step B can both be repeated n times to obtain n parameterized battery cycling swelling rate models and n parameterized battery storage swelling rate models, where each parameterized battery cycling swelling rate model and each parameterized battery storage swelling rate model are both subjected to the foregoing step C to ultimately obtain n battery swelling prediction curves, and the n battery swelling prediction curves are used as battery swelling rate models.

In this embodiment of this application, values are assigned to the constant coefficients in the battery cycling swelling rate model based on the battery cycling distribution functions, values are assigned to the constant coefficients in the battery storage swelling rate model based on the battery storage distribution functions, and these processes are repeated multiple times to obtain a third preset quantity of battery swelling prediction curves. In addition, a cumulative damage situation of the battery is considered in the process of determining the battery swelling prediction curves, and this allows the ultimately obtained battery swelling rate model to be more similar to an actual swelling situation of the battery.

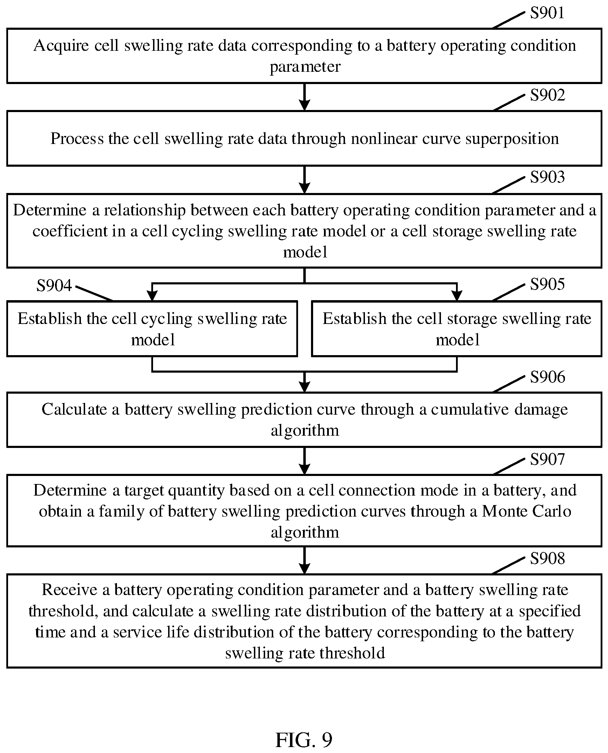

In an embodiment of this application, FIG. 9 is a flowchart of a fifth method for predicting swelling and life of a battery according to this embodiment of this application. The method includes the following steps.

Step S901. Acquire cell swelling rate data corresponding to a battery operating condition parameter.

Step S902. Process the cell swelling rate data through nonlinear curve superposition.

Step S903. Determine a relationship between each of the battery operating condition parameters and a coefficient in a cell cycling swelling rate model or a cell storage swelling rate model.

Step S904. Establish the cell cycling swelling rate model.

Step S905. Establish the cell storage swelling rate model.

Step S906. Calculate a battery swelling prediction curve through a cumulative damage algorithm.

Step S907. Determine a target quantity based on a cell connection mode in the battery, and obtain a family of battery swelling prediction curves through a Monte Carlo algorithm.

Step S908. Receive the battery operating condition parameter and a battery swelling rate threshold, and calculate a swelling rate distribution of the battery at a specified time and a life distribution of the battery corresponding to the battery swelling rate threshold.

Specifically, the implementation of the foregoing step S901 to step S908 may refer to the content of the foregoing descriptions, which are not repeated herein.

This application further provides an electrochemical apparatus. As shown in FIG. 10, the electrochemical apparatus 1000 includes a processor 1001 and a machine-readable storage medium 1002. Machine-executable instructions executable by the processor 1001 are stored in the machine-readable storage medium 1002, and when the processor 1001 executes the machine-executable instructions, the method for predicting swelling and life of a battery according to any one of the foregoing embodiments is implemented.

This application further provides an electric device including the electrochemical apparatus as described in the foregoing embodiment.

The machine-readable storage medium may include a random access memory (Random Access Memory, RAM), or may include a non-volatile memory (non-volatile memory), for example, at least one disk memory. Optionally, the memory may alternatively be at least one storage apparatus located far away from the processor.

The processor may be a universal processor, including a central processing unit (Central Processing Unit, CPU for short), a network processor (Network Processor, NP for short), and the like; or may be a digital signal processor (Digital Signal Processing, DSP for short), an application-specific integrated circuit (Application Specific Integrated Circuit, ASIC for short), a field-programmable gate array (Field-Programmable Gate Array, FPGA for short) or other programmable logic device, a discrete gate or transistor logic device, a discrete hardware component, or the like.

It should be noted that relational terms such as "first" and "second" herein are only used to distinguish one entity or operation from another entity or operation, and do not necessarily require or imply that there is any such actual relationship or order between these entities or operations. In addition, the terms "comprise", "include", or any other variations thereof are intended to cover non-exclusive inclusions, such that a process, method, article or device including a series of elements not only includes these elements, but also includes other elements which are not expressly listed, or further includes elements which are inherent to such process, method, article or device. Without more constraints, an element preceded by "includes a..." does not preclude the presence of other identical elements in the process, method, article, or apparatus that includes the element.

All embodiments in this specification are described in a related manner. For a part that is the same or similar between some embodiments, reference may be made between some embodiments. Each embodiment focuses on differences from other embodiments.

## Claims

1. A method for predicting swelling and life of a battery, **characterized in that** the method comprises:
receiving one or more battery operating condition parameters and a battery swelling rate threshold;
acquiring multiple battery swelling rate versus battery life distribution curves according to the one or more battery operating condition parameters;
acquiring a life distribution of the battery corresponding to the battery swelling rate threshold based on the multiple battery swelling rate versus battery life distribution curves, or
acquiring a swelling rate distribution of the battery at a specified time or at a specified quantity of cycles based on the multiple battery swelling rate versus battery life distribution curves; wherein
the one or more of battery operating condition parameters comprise at least one of a temperature, a charge cut-off voltage, a discharge cut-off voltage, a charge rate, a discharge rate, a quantity of battery continuous cycles per day, a storage voltage, or a storage time; the battery swelling rate threshold is a maximum swelling rate allowable by the battery; the life of the battery is represented by time or a quantity of cycles; and
the quantity of battery continuous cycles per day is a quantity of cycles per day, wherein in each cycle, the battery is discharged from the charge cut-off voltage to the discharge cut-off voltage and then charged to the charge cut-off voltage.

2. The method according to claim 1, **characterized in that** the acquiring a life distribution of the battery corresponding to the battery swelling rate threshold based on the multiple battery swelling rate versus battery life distribution curves further comprises: acquiring a life of the battery corresponding to the battery swelling rate threshold, wherein
the life of the battery is represented by a time extremum corresponding to the battery swelling rate threshold or is represented by a time average corresponding to the battery swelling rate threshold;
or,
the acquiring a swelling rate distribution of the battery at a specified time or at a specified quantity of cycles based on the multiple battery swelling rate versus battery life distribution curves further comprises: acquiring a swelling rate of the battery, wherein
the swelling rate of the battery is represented by a swelling rate extremum of the battery at a specified time or at a specified quantity of cycles or is represented by a swelling rate average of the battery at a specified time or at a specified quantity of cycles.

3. The method according to claim 1 or 2, **characterized in that** the acquiring multiple battery swelling rate versus battery life distribution curves according to the one or more battery operating condition parameters further comprises: inputting the one or more battery operating condition parameters into a battery swelling rate model to obtain the multiple battery swelling rate versus battery life distribution curves.

4. The method according to claim 3, **characterized in that** the temperature is represented by geographical location data; and the inputting the one or more battery operating condition parameters into a battery swelling rate model to obtain the multiple battery swelling rate versus battery life distribution curves comprises:
inputting the geographical location data, the charge cut-off voltage, the discharge cut-off voltage, the charge rate, the discharge rate, and the quantity of battery continuous cycles per day into the battery swelling rate model to obtain multiple battery swelling rate versus battery life distribution curves.

5. The method according to claim 3 or 4, **characterized in that** the battery swelling rate model is obtained in the following manner:
acquiring a cell connection mode in the battery;
establishing a battery cycling swelling rate model of the battery based on the cell connection mode and a cell cycling swelling rate model;
establishing a battery storage swelling rate model of the battery based on the cell connection mode and a cell storage swelling rate model; and
establishing the battery swelling rate model of the battery based on the battery cycling swelling rate model and the battery storage swelling rate model; wherein
the cell cycling swelling rate model represents a relationship between a quantity of cell cycles and a cell swelling rate, and the cell storage swelling rate model represents a relationship between a cell storage time and the cell swelling rate.

6. The method according to claim 5, **characterized in that** the cell cycling swelling rate model is obtained in the following manner:
acquiring cell cycling swelling rate data of the battery corresponding to a cycling operating condition parameter set; and
establishing the cell cycling swelling rate model according to the cycling operating condition parameter set and the cell cycling swelling rate data, wherein the cell cycling swelling rate model represents a correspondence between the quantity of cell cycles and the cell swelling rate;
and/or,
the cell storage swelling rate model is obtained in the following manner:
acquiring cell storage swelling rate data of the battery corresponding to a storage operating condition parameter set; and
establishing the cell storage swelling rate model according to the storage operating condition parameter set and the cell storage swelling rate data, wherein the cell storage swelling rate model represents a correspondence between the cell storage time and the cell swelling rate.

7. The method according to claim 6, **characterized in that** the cycling operating condition parameter set comprises multiple cycling operating condition parameter groups; each cycling operating condition parameter group comprises multiple first parameter items; the multiple first parameter items comprise a cycling parameter and at least one another parameter; values of a same first parameter item in different cycling operating condition parameter groups are not all the same; each cycling operating condition parameter group corresponds to one group of cell cycling swelling rate data; and
the storage operating condition parameter set comprises multiple storage operating condition parameter groups; each storage operating condition parameter group comprises multiple second parameter items; the multiple second parameter items comprise a storage parameter and at least one another parameter; values of a same second parameter item in different storage operating condition parameter groups are not all the same; and each storage operating condition parameter group corresponds to one group of cell storage swelling rate data.

8. The method according to claim 7, **characterized in that** the cell cycling swelling rate data is obtained by fitting electrode plate cycling swelling rate data and gas cycling swelling rate data, and the cell storage swelling rate data is obtained by fitting electrode plate storage swelling rate data and gas storage swelling rate data.

9. An electrochemical apparatus, comprising a processor and a machine-readable storage medium, **characterized in that** a machine-executable instruction executable by the processor is stored in the machine-readable storage medium, and when the processor executes the machine-executable instruction, the method according to any one of claims 1 to 8 is performed.

10. An electric device, **characterized in that** the electric device comprises the electrochemical apparatus according to claim 9.

## Patentansprüche

1. Verfahren zur Vorhersage von Quellung und Lebensdauer einer Batterie, **dadurch gekennzeichnet, dass** das Verfahren umfasst:
Empfangen eines oder mehrerer Batteriebetriebszustandsparameter und eines Schwellenwerts für die Batteriequellrate;
Erfassen mehrerer Kurven der Batteriequellrate im Verhältnis zur Batterielebensdauerverteilung gemäß dem einen oder der mehreren Batteriebetriebszustandsparametern;
Erfassen einer Lebensdauerverteilung der Batterie, die dem Schwellenwert für die Batteriequellrate basierend auf den mehreren Kurven der Batteriequellrate im Verhältnis zur Batterielebensdauerverteilung entspricht, oder
Erfassen einer Quellratenverteilung der Batterie zu einem bestimmten Zeitpunkt oder bei einer bestimmten Anzahl von Zyklen basierend auf den mehreren Kurven der Batteriequellrate im Verhältnis zur Batterielebensdauerverteilung; wobei
der eine oder die mehreren Batteriebetriebszustandsparameter mindestens eines von einer Temperatur, einer Ladeabschaltspannung, einer Entladeabschaltspannung, einer Laderate, einer Entladerate, einer Anzahl von kontinuierlichen Batteriezyklen pro Tag, einer Speicherspannung oder einer Speicherzeit umfasst; wobei der Schwellenwert für die Batteriequellrate eine maximale Quellrate ist, die von der Batterie zulässig ist; die Lebensdauer der Batterie als Zeit oder eine Anzahl von Zyklen dargestellt wird; und
die Anzahl der kontinuierlichen Batteriezyklen pro Tag eine Anzahl von Zyklen pro Tag ist, wobei in jedem Zyklus die Batterie von der Ladeabschaltspannung auf die Entladeabschaltspannung entladen und dann auf die Ladeabschaltspannung geladen wird.

2. Verfahren nach Anspruch 1, **dadurch gekennzeichnet, dass** das Erfassen einer Lebensdauerverteilung der Batterie entsprechend des Schwellenwerts für die Batteriequellrate basierend auf den mehreren Kurven der Batteriequellrate im Verhältnis zur Batterielebensdauerverteilung ferner Folgendes umfasst: Erfassen einer Lebensdauer der Batterie entsprechend des Schwellenwerts für die Batteriequellrate, wobei
die Lebensdauer der Batterie durch ein Zeitextrem, das dem Schwellenwert für die Batteriequellrate entspricht, oder durch einen Zeitdurchschnitt, der dem Schwellenwert für die Batteriequellrate entspricht, dargestellt wird;
oder
das Erfassen einer Quellratenverteilung der Batterie zu einem bestimmten Zeitpunkt oder bei einer bestimmten Anzahl von Zyklen basierend auf den mehreren Kurven der Batteriequellrate im Verhältnis zur Batterielebensdauerverteilung ferner Folgendes umfasst: das Erfassen einer Quellrate der Batterie, wobei
die Quellrate der Batterie durch ein Quellratenextrem, das der Batterie zu einem bestimmten Zeitpunkt oder bei einer bestimmten Anzahl von Zyklen entspricht, dargestellt wird oder durch einen Quellratendurchschnitt der Batterie zu einem bestimmten Zeitpunkt oder bei einer bestimmten Anzahl von Zyklen dargestellt wird.

3. Verfahren nach Anspruch 1 oder 2, **dadurch gekennzeichnet, dass** das Erfassen von den mehreren Kurven der Batteriequellrate im Verhältnis zur Batterielebensdauerverteilung gemäß dem einen oder den mehreren Batteriebetriebszustandsparametern ferner Folgendes umfasst: Eingeben der einen oder der mehreren Batteriebetriebszustandsparameter in ein Batteriequellratenmodell, um die mehreren Kurven der Batteriequellrate im Verhältnis zur Batterielebensdauerverteilung zu erhalten.

4. Verfahren nach Anspruch 3, **dadurch gekennzeichnet, dass** die Temperatur durch geografische Standortdaten dargestellt wird; und das Eingeben des einen oder der mehreren Batteriebetriebszustandsparameter in ein Batteriequellratenmodell zum Erhalten der mehreren Kurven der Batteriequellrate im Verhältnis zur Batterielebensdauerverteilung Folgendes umfasst:
Eingeben der geografischen Standortdaten, der Ladeabschaltspannung, der Entladeabschaltspannung, der Laderate, der Entladerate und der Anzahl der kontinuierlichen Batteriezyklen pro Tag in das Batteriequellratenmodell, um mehrere Kurven der Batteriequellrate im Verhältnis zur Batterielebensdauerverteilung zu erhalten.

5. Verfahren nach Anspruch 3 oder 4, **dadurch gekennzeichnet, dass** das Batteriequellratenmodell wie folgt erhalten wird:
Erfassen eines Zellverbindungsmodus in der Batterie;
Erstellen eines Batteriezyklus-Quellratenmodells der Batterie basierend auf dem Zellverbindungsmodus und einem Zellzyklus-Quellratenmodell;
Erstellen eines Batteriespeicher-Quellratenmodells der Batterie basierend auf dem Zellverbindungsmodus und einem Zellspeicher-Quellratenmodell; und
Erstellen des Batteriequellratenmodells der Batterie basierend auf dem Batteriezyklus-Quellratenmodell und dem Batteriespeicher-Quellratenmodell; wobei
das Zellzyklus-Quellratenmodell eine Beziehung zwischen einer Anzahl von Zellzyklen und einer Zellquellrate darstellt, und das Zellspeicher-Quellratenmodell eine Beziehung zwischen einer Zellspeicherzeit und der Zellquellrate darstellt.

6. Verfahren nach Anspruch 5, **dadurch gekennzeichnet, dass** das Zellzyklus-Quellratenmodell wie folgt erhalten wird:
Erfassen von Zellzyklus-Quellratendaten der Batterie entsprechend einem Satz von Zyklusbetriebszustandsparametern; und
Erstellen des Zellzyklus-Quellratenmodells entsprechend dem Satz von Zyklusbetriebszustandsparametern und den Zellzyklus-Quellratendaten, wobei das Zellzyklus-Quellratenmodell eine Übereinstimmung zwischen der Anzahl der Zellzyklen und der Zellquellrate darstellt;
und/oder
das Zellspeicher-Quellratenmodell wie folgt erhalten wird:
Erfassen von Zellspeicher-Quellratendaten der Batterie entsprechend einem Satz von Speicherbetriebszustandsparametern; und
Erstellen des Zellspeicher-Quellratenmodells entsprechend dem Satz von Speicherbetriebszustandsparametern und den Zellspeicher-Quellratendaten, wobei das Zellspeicher-Quellratenmodell eine Übereinstimmung zwischen der Zellspeicherzeit und der Zellquellrate darstellt.

7. Verfahren nach Anspruch 6, **dadurch gekennzeichnet, dass** der Satz von Zyklusbetriebszustandsparametern mehrere Zyklusbetriebszustandsparametergruppen umfasst; jede Zyklusbetriebszustandsparametergruppe mehrere erste Parameterelemente umfasst; die mehreren ersten Parameterelemente einen Zyklusparameter und mindestens einen anderen Parameter umfassen; die Werte desselben ersten Parameterelements in verschiedenen Zyklusbetriebszustandsparametergruppen nicht alle gleich sind; jede Zyklusbetriebszustandsparametergruppe einer Gruppe von Zellzyklus-Quellratendaten entspricht; und
der Satz von Speicherbetriebszustandsparametern mehrere Speicherbetriebszustandsparametergruppen umfasst; jede Speicherbetriebszustandsparametergruppe mehrere zweite Parameterelemente umfasst; die mehreren zweiten Parameterelemente einen Speicherparameter und mindestens einen weiteren Parameter umfassen; die Werte desselben zweiten Parameterelements in verschiedenen Speicherbetriebszustandsparametergruppen nicht alle gleich sind; und jede Speicherbetriebszustandsparametergruppe einer Gruppe von Zellspeicher-Quellratendaten entspricht.

8. Verfahren nach Anspruch 7, **dadurch gekennzeichnet, dass** die Zellzyklus-Quellratendaten durch Anpassen von Elektrodenplattenzyklus-Quellratendaten und Gaszyklus-Quellratendaten erhalten werden und die Zellspeicher-Quellratendaten durch Anpassen von Elektrodenplattenspeicher-Quellratendaten und Gasspeicher-Quellratendaten erhalten werden.

9. Elektrochemische Vorrichtung, umfassend einen Prozessor und ein maschinenlesbares Speichermedium, **dadurch gekennzeichnet, dass** eine maschinenausführbare Anweisung, die von dem Prozessor ausführbar ist, in dem maschinenlesbaren Speichermedium gespeichert ist und, wenn der Prozessor die maschinenausführbare Anweisung ausführt, das Verfahren nach einem der Ansprüche 1 bis 8 durchgeführt wird.

10. Elektronisches Gerät, **dadurch gekennzeichnet, dass** das elektronische Gerät die elektrochemische Vorrichtung nach Anspruch 9 umfasst.

## Revendications

1. Un procédé de prédiction du gonflement et de la durée de vie d'une batterie, **caractérisé en ce que** le procédé comprend :
la réception d'un ou plusieurs paramètres de conditions de fonctionnement de la batterie et d'un seuil de taux de gonflement de la batterie ;
l'acquisition de multiples courbes de distribution du taux de gonflement de la batterie par rapport à la durée de vie de la batterie selon les un ou plusieurs paramètres de conditions de fonctionnement de la batterie ;
l'acquisition d'une distribution de durée de vie de la batterie correspondant au seuil de taux de gonflement de la batterie sur la base des multiples courbes de distribution du taux de gonflement de la batterie par rapport à la durée de vie de la batterie, ou
l'acquisition d'une distribution de taux de gonflement de la batterie à un moment spécifié ou à une quantité spécifiée de cycles sur la base des multiples courbes de distribution du taux de gonflement de la batterie par rapport à la durée de vie de la batterie ; dans lequel
les un ou plusieurs paramètres de conditions de fonctionnement de la batterie comprennent au moins l'un parmi une température, une tension de coupure de charge, une tension de coupure de décharge, un taux de charge, un taux de décharge, une quantité de cycles continus de la batterie par jour, une tension de stockage, ou un temps de stockage ; le seuil de taux de gonflement de la batterie est un taux de gonflement maximal admissible par la batterie ; la durée de vie de la batterie est représentée par le temps ou une quantité de cycles ; et
la quantité de cycles continus de la batterie par jour est une quantité de cycles par jour, dans laquelle, dans chaque cycle, la batterie est déchargée de la tension de coupure de charge à la tension de coupure de décharge puis chargée à la tension de coupure de charge.

2. Le procédé selon la revendication 1, **caractérisé en ce que** l'acquisition d'une distribution de durée de vie de la batterie correspondant au seuil de taux de gonflement de la batterie sur la base des multiples courbes de distribution du taux de gonflement de la batterie par rapport à la durée de vie de la batterie comprend en outre : l'acquisition d'une durée de vie de la batterie correspondant au seuil de taux de gonflement de la batterie, dans lequel
la durée de vie de la batterie est représentée par un temps extrême correspondant au seuil de taux de gonflement de la batterie ou est représentée par une moyenne de temps correspondant au seuil de taux de gonflement de la batterie ;
ou,
l'acquisition d'une distribution de taux de gonflement de la batterie à un moment spécifié ou à une quantité spécifiée de cycles sur la base des multiples courbes de distribution du taux de gonflement de la batterie par rapport à la durée de vie de la batterie comprend en outre : l'acquisition d'un taux de gonflement de la batterie, dans lequel
le taux de gonflement de la batterie est représenté par un taux de gonflement extrême de la batterie à un moment spécifié ou à une quantité spécifiée de cycles ou est représenté par une moyenne de taux de gonflement de la batterie à un moment spécifié ou à une quantité spécifiée de cycles.

3. Le procédé selon la revendication 1 ou 2, **caractérisé en ce que** l'acquisition de multiples courbes de distribution du taux de gonflement de la batterie par rapport à la durée de vie de la batterie selon les un ou plusieurs paramètres de conditions de fonctionnement de la batterie comprend en outre : l'introduction des un ou plusieurs paramètres de conditions de fonctionnement de la batterie dans un modèle de taux de gonflement de la batterie pour obtenir les multiples courbes de distribution du taux de gonflement de la batterie par rapport à la durée de vie de la batterie.

4. Le procédé selon la revendication 3, **caractérisé en ce que** la température est représentée par des données de localisation géographique ; et l'introduction des un ou plusieurs paramètres de conditions de fonctionnement de la batterie dans un modèle de taux de gonflement de la batterie pour obtenir les multiples courbes de distribution du taux de gonflement de la batterie par rapport à la durée de vie de la batterie comprend :
l'introduction des données de localisation géographique, de la tension de coupure de charge, de la tension de coupure de décharge, du taux de charge, du taux de décharge, et de la quantité de cycles continus de la batterie par jour dans le modèle de taux de gonflement de la batterie pour obtenir les multiples courbes de distribution du taux de gonflement de la batterie par rapport à la durée de vie de la batterie.

5. Le procédé selon la revendication 3 ou 4, **caractérisé en ce que** le modèle de taux de gonflement de la batterie est obtenu de la manière suivante :
l'acquisition d'un mode de connexion de cellule dans la batterie ;
l'établissement d'un modèle de taux de gonflement de cyclage de la batterie basé sur le mode de connexion de cellule et un modèle de taux de gonflement de cyclage de cellule ;
l'établissement d'un modèle de taux de gonflement de stockage de la batterie basé sur le mode de connexion de cellule et un modèle de taux de gonflement de stockage de cellule ; et
l'établissement du modèle de taux de gonflement de la batterie basé sur le modèle de taux de gonflement de cyclage de la batterie et le modèle de taux de gonflement de stockage de la batterie ; dans lequel
le modèle de taux de gonflement de cyclage de cellule représente une relation entre une quantité de cycles de cellule et un taux de gonflement de cellule, et le modèle de taux de gonflement de stockage de cellule représente une relation entre un temps de stockage de cellule et le taux de gonflement de cellule.

6. Le procédé selon la revendication 5, **caractérisé en ce que** le modèle de taux de gonflement de cyclage de cellule est obtenu de la manière suivante :
l'acquisition de données de taux de gonflement de cyclage de cellule de la batterie correspondant à un ensemble de paramètres de conditions de fonctionnement de cyclage ; et
l'établissement du modèle de taux de gonflement de cyclage de cellule selon l'ensemble de paramètres de conditions de fonctionnement de cyclage et les données de taux de gonflement de cyclage de cellule, dans lequel le modèle de taux de gonflement de cyclage de cellule représente une correspondance entre la quantité de cycles de cellule et le taux de gonflement de cellule ;
et/ou,
le modèle de taux de gonflement de stockage de cellule est obtenu de la manière suivante :
l'acquisition de données de taux de gonflement de stockage de cellule de la batterie correspondant à un ensemble de paramètres de conditions de fonctionnement de stockage ; et
l'établissement du modèle de taux de gonflement de stockage de cellule selon l'ensemble de paramètres de conditions de fonctionnement de stockage et les données de taux de gonflement de stockage de cellule, dans lequel le modèle de taux de gonflement de stockage de cellule représente une correspondance entre le temps de stockage de cellule et le taux de gonflement de cellule.

7. Le procédé selon la revendication 6, **caractérisé en ce que** l'ensemble de paramètres de conditions de fonctionnement de cyclage comprend de multiples groupes de paramètres de conditions de fonctionnement de cyclage ; chaque groupe de paramètres de conditions de fonctionnement de cyclage comprend de multiples premiers éléments de paramètre ; les multiples premiers éléments de paramètre comprennent un paramètre de cyclage et au moins un autre paramètre ; les valeurs d'un même premier élément de paramètre dans différents groupes de paramètres de conditions de fonctionnement de cyclage ne sont pas toutes les mêmes ; chaque groupe de paramètres de conditions de fonctionnement de cyclage correspond à un groupe de données de taux de gonflement de cyclage de cellule ; et
l'ensemble de paramètres de conditions de fonctionnement de stockage comprend de multiples groupes de paramètres de conditions de fonctionnement de stockage ; chaque groupe de paramètres de conditions de fonctionnement de stockage comprend de multiples seconds éléments de paramètre ; les multiples seconds éléments de paramètre comprennent un paramètre de stockage et au moins un autre paramètre ; les valeurs d'un même second élément de paramètre dans différents groupes de paramètres de conditions de fonctionnement de stockage ne sont pas toutes les mêmes ; et chaque groupe de paramètres de conditions de fonctionnement de stockage correspond à un groupe de données de taux de gonflement de stockage de cellule.

8. Le procédé selon la revendication 7, **caractérisé en ce que** les données de taux de gonflement de cyclage de cellule sont obtenues par ajustement des données de taux de gonflement de cyclage de plaque d'électrode et des données de taux de gonflement de cyclage de gaz, et les données de taux de gonflement de stockage de cellule sont obtenues par ajustement des données de taux de gonflement de stockage de plaque d'électrode et des données de taux de gonflement de stockage de gaz.

9. Un appareil électrochimique, comprenant un processeur et un support de stockage lisible par machine, **caractérisé en ce qu'**une instruction exécutable par machine, exécutable par le processeur, est stockée dans le support de stockage lisible par machine, et lorsque le processeur exécute l'instruction exécutable par machine, le procédé selon l'une quelconque des revendications 1 à 8 est mis en œuvre.

10. Un dispositif électrique, **caractérisé en ce que** le dispositif électrique comprend l'appareil électrochimique selon la revendication 9.
